# EUROPÄISCHE PATENTSCHRIFT

(11) **EP 1 489 733 B1**
(45) Veröffentlichungstag und Bekanntmachung des Hinweises auf die Patenterteilung: **25.03.2009**
(21) Anmeldenummer: 04011126.2
(22) Anmeldetag: 11.05.2004
(51) Int. Cl.: G06K 19/077, H02M 7/00, H01L 27/06, H01L 27/07

(54) **Gleichrichterschaltung für Transponder**
Rectifier circuit for transponder
Circuit redresseur pour transpondeur

(30) Priorität: 21.05.2003 DE 10322888
(43) Veröffentlichungstag der Anmeldung: 22.12.2004
(73) Patentinhaber: ATMEL Germany GmbH, 74072 Heilbronn (DE)
(72) Erfinder: Friedrich, Ulrich Dipl.-Ing., 74248 Ellhofen (DE); Fischer, Martin Dipl.-Ing., 74629 Gleichen (DE)
(74) Vertreter: Koch Müller Patentanwaltsgesellschaft mbH

(56) Entgegenhaltungen:
- US-A1- 6 011 488
- US-B1- 6 492 192

## Beschreibung

Die Erfindung bezieht sich auf einen integrierten Schaltkreis nach dem Oberbegriff des Anspruchs 1. Derartige integrierte Schaltkreise, die einen passiven oder semipassiven, rückstreubasierten Transponder und einen Gleichrichter umfassen, finden beispielsweise bei kontaktlosen Identifikationssystemen oder sogenannten RFID-Systemen Verwendung, bei denen zwischen einer oder mehreren Basisstationen bzw. Lesegeräten und einem oder mehreren Transpondern draht- bzw. kontaktlos Daten übertragen werden. Auf dem integrierten Schaltkreis können auch Sensoren, beispielsweise zur Temperaturmessung, integriert sein. Derartige Transponder werden auch als Remote-Sensoren bezeichnet.

Die Transponder bzw. deren Sende- und Empfangseinrichtungen verfügen üblicherweise nicht über einen aktiven Sender für die Datenübertragung zur Basisstation. Bei solchen nicht aktiven Systemen, die als passive Systeme bezeichnet werden, wenn sie keine eigene Energieversorgung aufweisen, und als semipassive Systeme bezeichnet werden, wenn sie eine eigene Energieversorgung aufweisen, wird zur Datenübertragung bei Entfernungen von deutlich mehr als einem Meter in Verbindung mit UHF oder Mikrowellen in der Regel die sogenannte Backscatter- oder Rückstreukopplung eingesetzt. Hierzu werden von der Basisstation elektromagnetische Wellen emittiert, die durch die Sendeund Empfangseinrichtung des Transponders entsprechend den an die Basisstation zu übertragenden Daten mit einem Modulationsverfahren moduliert und reflektiert werden. Dies geschieht im Allgemeinen durch eine Eingangsimpedanzänderung der Sende- und Empfangseinrichtung, die eine Veränderung der Reflexionseigenschaften einer daran angeschlossenen Antenne bewirkt.

Hierfür werden zunehmend höhere Anforderungen an die Übertragungsreichweite gestellt. Bei passiven Transpondern bzw. Remote-Sensoren wird die zu deren Betrieb notwendige Leistung aus dem von der Basisstation emittierten elektromagnetischen Feld mit Hilfe einer Antenne entnommen, an die der Gleichrichter zur Erzeugung einer Betriebsspannung angeschlossen ist. Der Gleichrichter ist üblicherweise als ein- oder mehrstufige Spannungsverdopplerschaltung ausgeführt, die Gleichrichterdioden zur Realisierung der Gleichrichterfunktion enthält, die bei Betriebsfrequenzen im UHF-Bereich oder darüber meist als Schottky-Dioden ausgeführt sind.

Bei Integration, beispielsweise in einem CMOS-Prozess, weisen die Schottky-Dioden in der Regel jeweils einen Bezugsanschluss zum Anschluss an ein Bezugspotential, einen ersten Nutzanschluss und einen zweiten Nutzanschluss auf, wobei die Diodenstrecke zwischen dem ersten und dem zweiten Nutzanschluss gebildet ist und zwischen dem Bezugsanschluss und dem ersten Nutzanschluss eine parasitäre Impedanz besteht.

Die parasitäre Impedanz, insbesondere deren durch ohmsche Anteile bedingter Realteil, mindert den Wirkungsgrad der Gleichrichterschaltung, da unter anderem in den ohmschen Anteilen ein großer Teil der Empfangsleistung verbraucht wird. Die parasitäre Impedanz hat zudem in der Regel, bedingt durch die ohmschen Anteile, einen sehr ungünstigen Gütewert Q, so dass sich eine Fehlanpassung durch Verwendung von Anpassnetzwerken schlecht reduzieren bzw. eliminieren lässt.

Die US 6,011,488 zeigt einen integrierten Schaltkreis mit einem Transponder und einem Gleichrichter, der als Spannungsversorgung des Transponders dient.

Der Erfindung liegt als technisches Problem die Bereitstellung eines integrierten Schaltkreises der eingangs genannten Art zugrunde, der eine Datenübertragung zwischen einer Basisstation und dem Transponder mit relativ großer Reichweite ermöglicht und mit relativ geringem Auf wand realisierbar ist.

Die Erfindung löst dieses Problem durch die Bereitstellung eines integrierten Schaltkreises mit den Merkmalen des Anspruchs 1.

Erfindungsgemäß liegt derjenige Nutzanschluss mindestens einer Gleichrichterdiode, der die parasitäre Impedanz zum Bezugsanschluss aufweist, auf dem Bezugspotential, an das der Bezugsanschluss der Diode anzuschließen ist. Mit Hilfe dieser Maßnahme verringert sich die Summe aller parasitären Impedanzen in den Eingangskreisen, da die parasitäre Impedanz zwischen dem betreffendern Nutzanschluss und dem Bezugsanschluss durch diese Maßnahme kurzgeschlossen wird. Aufgrund der derart verringerten parasitären Impedanzen erhöht sich der Wirkungsgrad des Gleichrichters, wodurch sich die Übertragungsreichweite zwischen einer Basisstation und dem Transponder erhöht. Die Gleichrichterdioden sind hierbei typischerweise Schottky-Dioden, können jedoch auch beliebige, als Dioden wirkende Halbleiterstrukturen sein, beispielsweise als Dioden beschaltete Feldeffekt-Transistoren bzw. Bipolar-Transistoren.

In einer Weiterbildung des integrierten Schaltkreises nach Anspruch 2 ist das Bezugspotential Massepotential. Dies führt insbesondere zu einfachen Layouts, da das Massepotential üblicherweise an vielen Stellen des integrierten Schaltkreises vorhanden ist.

In einer Weiterbildung des integrierten Schaltkreises nach Anspruch 3 ist zur Ausbildung der Schottky-Dioden jeweils ein dotierter Wannenbereich in einem Halbleitersubstrat vorgesehen und auf der Oberfläche des dotierten Wannenbereichs sind der zweite Nutzanschluss als Metall-Halbleiter-Übergang und der erste Nutzanschluss mit Abstand zum zweiten Nutzanschluss in einem Randbereich ausgebildet und der Bezugsanschluss ist auf der Oberfläche des Halbleitersubsträts benachbart zum dotierten Wannenbereich ausgebildet. Derart gebildete Schottky-Dioden sind einfach und mit bekannten Prozessschritten herstellbar.

In einer Weiterbildung des integrierten Schaltkreises nach Anspruch 4 ist der Gleichrichter in Villardschaltung ausgeführt. Die Villardschaltung kann ein- oder mehrstufig sein. Vorzugsweise ist diejenige Gleichrichterdiode, die mit ihrem ersten, eine Anode bildenden Nutzanschluss mit dem Bezugspotential verbunden ist, als p-Schottky-Diode auf einem p-leitenden Halbleitersubstrat ausgeführt. Alternativ kann diejenige Gleichrichterdiode, die mit ihrem ersten, eine Kathode bildenden Nutzanschluss mit dem Bezugspotential verbunden ist, als n-Schottky-Diode auf einem n-leitenden Halbleitersubstrat ausgeführt sein. Durch eine derartige Beschaltung wird jeweils die parasitäre Impedanz zwischen erstem Nutzanschluss und Bezugspotential kurzgeschlossen.

In einer Weiterbildung des integrierten Schaltkreises nach Anspruch 7 ist der Gleichrichter in Greinacherschaltung ausgeführt. Die Greinacherschaltung kann ein- oder mehrstufig sein. Vorzugsweise ist diejenige Gleichrichterdiode, die mit ihrem ersten, eine Anode bildenden Nutzanschluss mit dem Bezugspotential verbunden ist, als p-Schottky-Diode auf einem p-leitenden Halbleitersubstrat ausgeführt und/oder diejenige Gleichrichterdiode, die mit ihrem zweiten, eine Kathode bildenden Nutzanschluss mit dem Ausgangsanschluss des Gleichrichters verbunden ist, als n- Schottky-Diode auf einem p-leitenden Halbleitersubstrat ausgeführt. Alternativ kann diejenige Gleichrichterdiode, die mit ihrem ers ten, eine Anode bildenden Nutzanschluss mit dem Bezugspotential verbunden ist, als p-Schottky-Diode auf einem n-leitenden Halbleitersubstrat ausgeführt sein und/oder diejenige Gleichrichterdiode, die mit ihrem zweiten, eine Kathode bildenden Nutzanschluss mit der Ausgangsspannung des Gleichrichters verbunden ist, als p-Schottky-Diode auf einem n-leitenden Halbleitersubstrat ausgeführt sein.

In einer Weiterbildung des integrierten Schaltkreises nach Anspruch 10 sind zur Verringerung der parasitären Eigenschaften der Gleichrichterdiode Leitbahnstrukturen in geringem Abstand um diese angeordnet, die auf dem Bezugspotential, insbesondere Massepotential, liegen. Durch diese Maßnahme wird die Güte parasitärer Diodenstrecken verbessert.

Vorteilhafte Ausführungsformen der Erfindung sind in den Zeichnungen dargestellt und werden nachfolgend beschrieben. Hierbei zeigen:
- Fig. 1A: ein schematisches Schnittbild einer p-Schottky-Diode in einem p-dotierten Halbleitersubstrat,
- Fig. 1B: ein schematisches, vereinfachtes HF-Ersatzschaltbild der p-Schottky-Diode von Fig. 1A,
- Fig. 2A: ein schematisches Schnittbild einer n-Schottky-Diode in einem p-dotierten Halbleitersubstrat,
- Fig. 2B: ein schematisches, vereinfachtes HF-Ersatzschaltbild der n-Schottky-Diode von Fig. 2A,
- Fig. 3A: ein schematisches Schnittbild einer p-Schottky-Diode in einem n-dotierten Halbleitersubstrat,
- Fig. 3B: ein schematisches, vereinfachtes HF-Ersatzschaltbild der p-Schottky-Diode von Fig. 3A,
- Fig. 4A: ein schematisches Schnittbild einer n-Schottky-Diode in einem n-dotierten Halbleitersubstrat,
- Fig. 4B: ein schematisches, vereinfachtes HF-Ersatzschaltbild der n-Schottky-Diode von Fig. 4A,
- Fig. 5A: ein Schaltbild einer Villardschaltung in einem p-dotierten Halbleitersubstrat gemäß einer ersten Ausführungsform,
- Fig. 5B: ein Schaltbild einer Villardschaltung in einem p-dotierten Halbleitersubstrat gemäß einer zweiten Ausführungsform,
- Fig. 6A: ein Schaltbild einer Villardschaltung in einem n-dotierten Halbleitersubstrat gemäß einer ersten Ausführungsform,
- Fig. 6B: ein Schaltbild einer Villardschaltung in einem n-dotierten Halbleitersubstrat gemäß einer zweiten Ausführungsform,
- Fig. 7: ein Schaltbild einer Greinacherschaltung in einem p-dotierten Halbleitersubstrat,
- Fig. 8: ein Schaltbild einer Greinacherschaltung in einem n-dotierten Halbleitersubstrat,
- Fig. 9: ein schematisches Blockschaltbild eines integrierten Schaltkreises mit einem Gleichrichter und einem passiven, rückstreubasierten Transponder und
- Fig. 10: eine schematische Draufsicht auf eine Leitbahnstruktur zur Verringerung parasitärer Eigenschaften einer Schottky-Diode.

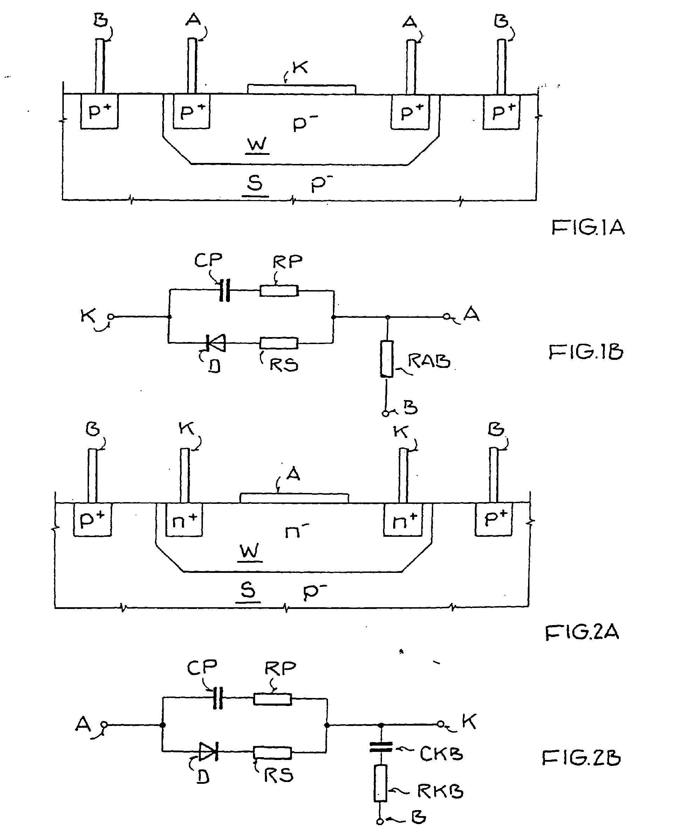

Die Fig. 1A bis 4B veranschaulichen verschiedene Typen von in einem Halbleitersubstrat realisierbaren Schottky-Dioden, wie sie für einen Gleichrichter in erfindungsgemäßen integrierten Schaltkreisen verwendbar sind.

Fig. 1A zeigt ein schematisches Schnittbild einer p-Schottky-Diode in einem p-dotierten Halbleitersubstrat S. Zur Bildung der Schottky-Diode ist ein p-dotierter Wannenbereich W in einem Halbleitersubstrat S vorgesehen, auf dessen Oberfläche eine Ringanode A als ein erster Nutzanschluss in einem Randbereich ausgeführt ist. Die Ringanode A kann kreisförmig, quadratisch, rechteckig oder in einer anderen Form ausgeführt sein. Das Substrat S kann auch als eine entsprechend dotierte Wanne ausgeführt sein. Eine Kathode K ist als ein zweiter Nutzanschluss als Metall-Halbleiter-Übergang im Inneren der Ringanode A auf der Oberfläche des Wannenbereichs W und ein ringförmiger Bezugsanschluss B ist benachbart zum dotierten Wannenbereich W auf der Oberfläche des Halbleitersubstrats S implementiert. Der Bezugsanschluss B dient zum Anschluss an ein Bezugspotential. Die Diodenstrecke ist zwischen dem ersten und dem zweiten Nutzanschluss A bzw. K gebildet.

Fig. 1B zeigt ein schematisches, vereinfachtes HF-Ersatzschaltbild der p-Schottky-Diode von Fig. 1A. Induktive Komponenten sind aufgrund der geometrischen Dimensionen vernachlässigbar. Zwischen Anode A und Kathode K liegt ein Widerstand RS in Serie mit,einer Diode D, welche die eigentliche Diodenstrecke darstellt. Parallel zur Diode D und zum Serienwiderstand RS liegen in Serie ein Widerstand RP und ein Kondensator CP, welche sogenannte Sperrschichtparasiten darstellen. Die parasitäre Impedanz zwischen dem Bezugsanschluss B und der Anode A, die den ersten Nutzanschluss bildet, ist durch einen Widerstand RAB repräsentiert. Diese parasitäre Impedanz, der sogenannte Wannenparasit, wird im Wesentlichen durch Effekte zwischen dem Wannenbereich W und dem umgebenden Halbleitersubstrat S verursacht.

Fig. 2A zeigt ein schematisches Schnittbild einer n-Schottky-Diode in einem p-dotierten Halbleitersubstrat S. Die gezeigte Implementierung entspricht bis auf die Dotierung des Wannenbereichs W derjenigen von Fig. 1A. Aufgrund dieser Dotierungsänderung sind Anode und Kathode im Vergleich zu Fig. 1A vertauscht. Der erste ringförmige Nutzanschluss im Randbereich des Wannenbereichs W ist in dieser Ausführungsform die Kathode K, der zweite Nutzanschluss die Anode A.

Fig. 2B zeigt ein schematisches, vereinfachtes HF-Ersatzschaltbild der n-Schottky-Diode von Fig. 2A. Im Vergleich zu Fig. 1B sind die Anode A und die Kathode K vertauscht und zwischen der Kathode K als dem ersten Nutzanschluss und dem Bezugsanschluss B liegen anstatt des Widerstands RAB von Fig. 1B ein Kondensator CKB und ein Widerstand RKB in Serie.

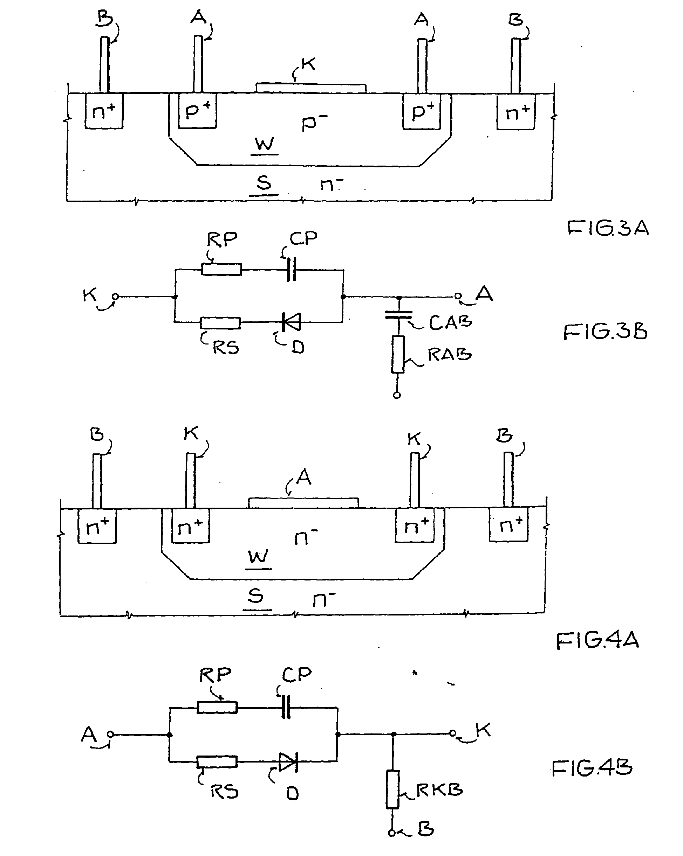

Fig. 3A zeigt ein schematisches Schnittbild einer p-Schottky-Diode in einem n-dotierten Halbleitersubstrat und Fig. 3B das zugehörige Ersatzschaltbild. Im Unterschied zu Fig. 1A ist das Substrat S hier n-dotiert, wodurch die parasitäre Impedanz zwischen der Anode A und dem Bezugsanschluss B zusätzlich eine kapazitive Komponente aufweist, die durch einen Kondensator CAB dargestellt ist. Der erste Nutzanschluss ist in dieser Ausführungsform die Anode A, der zweite Nutzanschluss die Kathode K.

Fig. 4A zeigt ein schematisches Schnittbild einer n-Schottky-Diode in einem n-dotierten Halbleitersubstrat und Fig. 4B das zugehörige Ersatzschaltbild. Im Unterschied zu Fig. 2A ist das Substrat S hier n-dotiert, wodurch sich eine allein durch den Widerstand RKB dargestellte parasitäre Impedanz zwischen der Kathode K und dem Bezugsanschluss B ergibt. Der erste Nutzanschluss ist in dieser Ausführungsform die Kathode K, der zweite Nutzanschluss die Anode A.

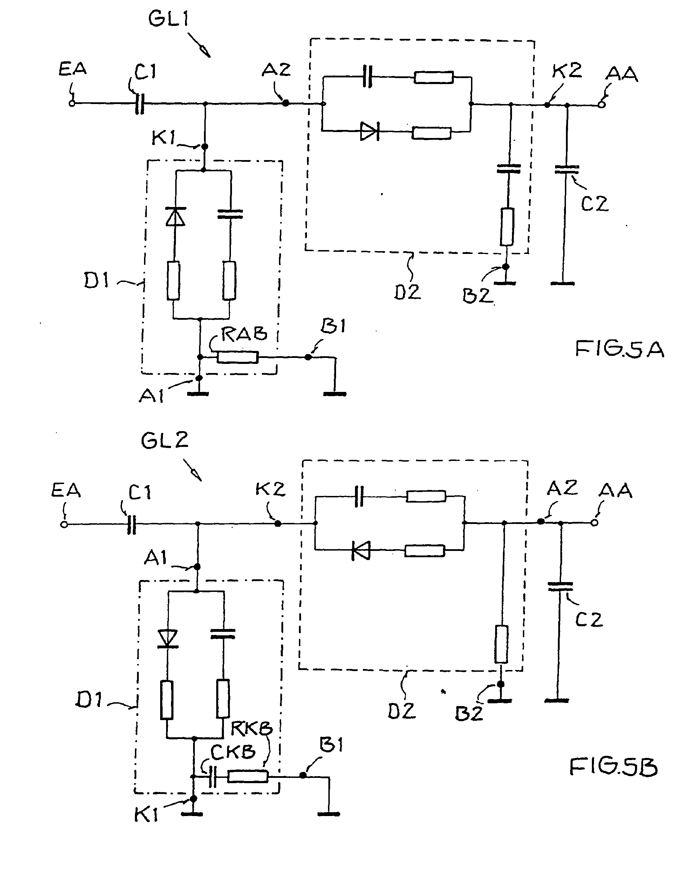

Fig. 5A zeigt ein Schaltbild eines Gleichrichters GL1 in Villardschaltung, der in einem p-dotierten Halbleitersubstrat realisierbar ist, gemäß einer ersten Ausführungsform. Eine nicht gezeigte Antenne wird an einen Eingangsanschluss EA und ein Masse-Bezugspotential angeschlossen. Eine Betriebsspannung wird zwischen einem Ausgangsanschluss AA und dem Masse-Bezugspotential abgegriffen. Zwischen den Eingangsanschluss EA und den Ausgangsanschluss AA sind ein Kondensator C1 und eine Diode D2 in Serie eingeschleift. Die Diode D2 ist als n-Schottky-Diode nach Art von Fig. 2A ausgeführt und anhand ihres HF-Ersatzschaltbildes gemäß Fig. 2B dargestellt. Ein Kathodenanschluss K2 der Diode D2 ist mit dem Ausgangsanschluss AA verbunden. Zwischen den Ausgangsanschluss AA und das Masse-Bezugspotential ist ein Kondensator C2 eingeschleift. Ein Anodenanschluss A2 der Diode D2 ist mit einem Kathodenanschluss K1 einer Diode D1 und dem Kondensator C1 verbunden. Die Diode D1 ist als p-Schottky-Diode nach Art von Fig. 1A ausgeführt und anhand ihres HF-Ersatzschaltbildes gemäß Fig. 1B dargestellt. Ihr Anodenanschluss A1, d.h. ihr erster Nutzanschluss, ist wie ihr Bezugsanschluss B1 mit Masse verbunden. Die parasitäre Impedanz RAB der Diode D1 wird folglich kurzgeschlossen, wodurch sich der Wirkungsgrad des Gleichrichters GL1 deutlich verbessert.

Fig. 5B zeigt ein Schaltbild eines Gleichrichters GL2 in Villardschaltung, der sich ebenfalls in einem p-dotierten Halbleitersubstrat realisieren lässt, gemäß einer zweiten Ausführungsform. Im Unterschied zu Fig. 5A sind hier die Diode D1 als n-Schottky-Diode nach Art von Fig. 2A und die Diode D2 als p-Schottky-Diode nach Art von Fig. 1A ausgeführt und die Durchlassrichtung der Dioden D1 und D2 ist invertiert. Der Anodenanschluss A2 der Diode D2 ist mit dem Ausgangsanschluss AA verbunden. Der Kathodenanschluss K2 der Diode D2 ist mit dem Anodenanschluss A1 der Diode D1 und dem Kondensator C1 verbunden. In dieser Beschaltung erzeugt der Gleichrichter GL2 an seinem Ausgangsanschluss AA eine negative Versorgungsspannung. Da der Kathodenanschluss K1 der Diode D1, d.h. ihr erster Nutzanschluss, wie ihr Bezugsanschluss B1 auf Masse liegt, ist die aus CKB und RKB gebildete parasitäre Impedanz kurzgeschlossen, wodurch sich der Wirkungsgrad des Gleichrichters GL2 deutlich verbessert.

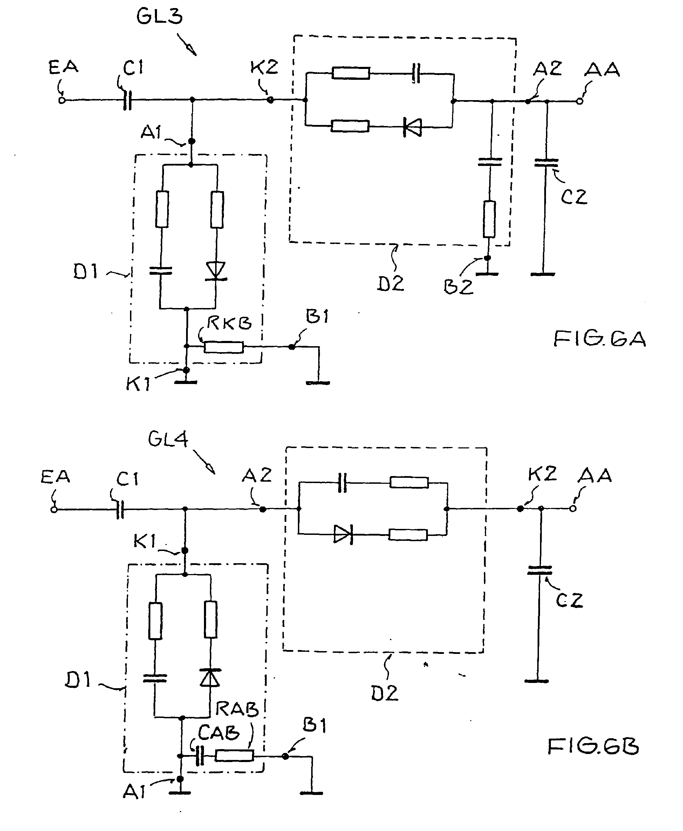

Fig. 6A zeigt ein Schaltbild eines Gleichrichters GL3 in Villardschaltung in einem n-dotierten Halbleitersubstrat, bei der die Diode D1 als n-Schottky-Diode nach Art von Fig. 4A und die Diode D2 als p-Schottky-Diode nach Art von Fig. 3A ausgeführt sind. Der Gleichrichter GL3 erzeugt an seinem Ausgangsanschluss AA eine negative Versorgungsspannung. Da der Kathodenanschluss K1 der Diode D1, d.h. ihr erster Nutzanschluss, wie ihr Bezugsanschluss B1 auf Masse liegt, ist die parasitäre Impedanz RKB der Diode D1 kurzgeschlossen, wodurch sich der Wirkungsgrad des Gleichrichters GL3 deutlich verbessert.

Fig. 6B zeigt ein Schaltbild eines Gleichrichters GL4 in Villardschaltung in einem n-dotierten Halbleitersubstrat, bei der die Dioden D1 und D2 als p-Schottky-Dioden nach Art von Fig. 3A ausgeführt sind. Der Anodenanschluss A1 der Diode D1, d.h. ihr erster Nutzanschluss, ist wie ihr Bezugsanschluss B1 mit Masse verbunden. Folglich ist die aus CAB und RAB gebildete parasitäre Impedanz kurzgeschlossen, wodurch sich der Wirkungsgrad des Gleichrichters GL4 deutlich verbessert.

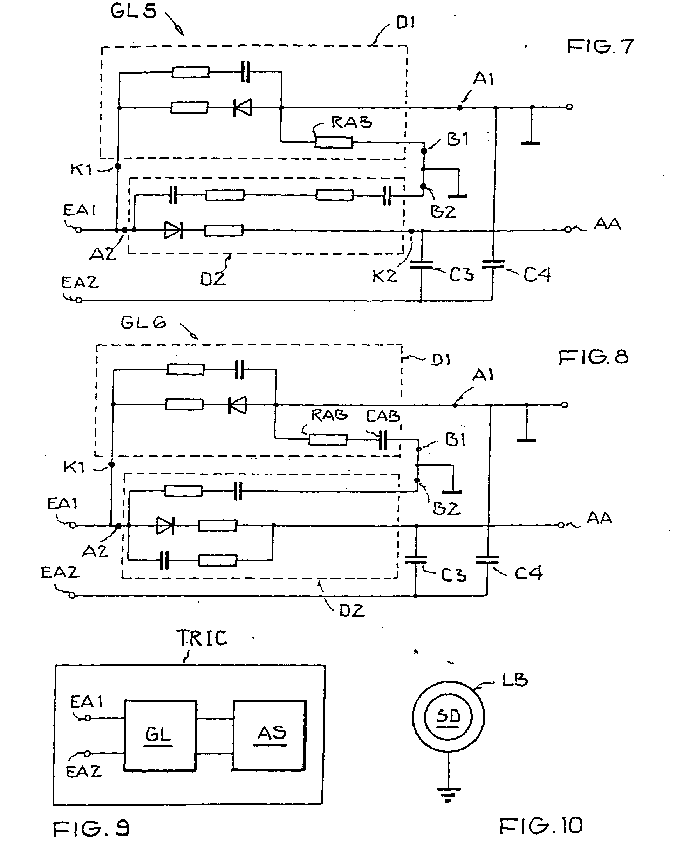

Fig. 7 zeigt ein Schaltbild eines Gleichrichters GL5 in Greinacherschaltung in einem p-dotierten Halbleitersubstrat. Eine nicht gezeigte Antenne wird an Eingangsanschlüsse EA1 und EA2 angeschlossen. Eine Betriebsspannung wird zwischen einem Ausgangsanschluss AA und einem Masse-Bezugspotential abgegriffen. Zwischen den ersten Eingangsanschluss EA1 und den Ausgangsanschluss AA ist eine Diode D2 eingeschleift. Die Diode D2 ist als n-Schottky-Diode nach Art von Fig. 2A ausgeführt und anhand ihres HF-Ersatzschaltbildes gemäß Fig. 2B dargestellt. Ein Kathodenanschluss K2 der Diode D2 ist mit dem Ausgangsanschluss AA verbunden. Zwischen den Ausgangsanschluss AA und den zweiten Eingangsanschluss EA2 ist ein Kondensator C3 eingeschleift und zwischen das Masse-Bezugspotential und den zweiten Eingangsanschluss EA2 ist ein Kondensator C4 eingeschleift. Ein Anodenanschluss A2 der Diode D2 ist mit einem Kathodenanschluss K1 einer Diode D1 und dem ersten Eingangsanschluss EA1 verbunden. Die Diode D1 ist als p-Schottky-Diode nach Art von Fig. 1A ausgeführt und anhand ihres HF-Ersatzschaltbildes gemäß Fig. 1B dargestellt. Ihr Anodenanschluss A1, d.h. ihr erster Nutzanschluss, ist wie ihr Bezugsanschluss B1 mit Masse verbunden. Die parasitäre Impedanz RAB der Diode D1 wird folglich kurzgeschlossen, wodurch sich der Wirkungsgrad des Gleichrichters GL5 deutlich verbessert.

Fig. 8 zeigt ein Schaltbild eines Gleichrichters GL6 in Greinacherschaltung in einem n-dotierten Halbleitersubstrat mit wiederum zwei Dioden D1 und D2, die in diesem Fall als p-Schottky-Dioden nach Art von Fig. 3A ausgeführt sind. Der Anodenanschluss A1 der Diode D1, d.h. ihr erster Nutzanschluss, ist wie ihr Bezugsanschluss B1 mit Masse verbunden. Die parasitäre Impedanz der Diode D1, bestehend aus dem Widerstand RAB und dem Kondensator CAB, die in Serie geschaltet sind, wird folglich kurzgeschlossen, wodurch sich der Wirkungsgrad des Gleichrichters GL6 deutlich verbessert.

Die gezeigten Gleichrichter GL1 bis GL6 können zur Erzeugung einer Versorgungsspannung verwendet werden, sind jedoch auch zur Verwendung als Detektorschaltung oder als sogenannte Receiver-Signal-Strength-Indicator(RSSI)-Schaltung zur Detektion von Spannungseinbrüchen in Verbindung mit einer Trägerwelle geeignet. Die gezeigten Dioden können sich jeweils auch aus einer Parallelschaltung von mehreren Dioden zusammensetzen.

Allen gezeigten Ausführungsformen ist gemeinsam, dass die parasitären Komponenten der Gleichrichter GL1 bis GL6 dadurch minimiert werden, dass derjenige Nutzanschluss der Gleichrichterdioden, der eine parasitäre Impedanz zum Bezugsanschluss aufweist, auf Bezugspotential liegt. Hierdurch erhöht sich die erzielbare Reichweite der Datenübertragung zwischen einer Basisstation und dem Transponder.

Fig. 9 zeigt ein schematisches Blockschaltbild eines integrierten Schaltkreises in Form eines Transponder-ICs TRIC mit einem Gleichrichter GL eines der oben erläuterten Typen gemäß den Fig. 5A bis Fig. 8 und einer Auswerteschaltung AS, die beispielsweise eine nicht gezeigte finite Zustandsmaschine und analoge Schaltungseinheiten umfasst. Der Transponder-IC TRIC bzw. dessen Auswerteschaltung AS realisiert einen passiven, rückstreubasierten Transponder. An Eingangsanschlüsse EA1 und EA2 des Gleichrichters GL wird eine nicht gezeigte Antenne angeschlossen, welche die zum Betrieb des Transponder-ICs TRIC benötigte Leistung aus einem von einer nicht gezeigten Basisstation emittierten elektromagnetischen Feld entnimmt. Der Gleichrichter GL erzeugt eine Betriebsspannung, die zur Versorgung des Transponder-ICs TRIC bzw. dessen Auswerteschaltung AS dient.

Fig. 10 zeigt eine schematische Draufsicht auf eine Leitbahnstruktur LB zur Verringerung parasitärer Eigenschaften einer Schottky-Diode SD. Die Leitbahnstruktur LB ist als eine ringförmige Leiterbahn realisiert, die mit minimalem Abstand um die jeweilige Schottky-Diode SD angeordnet ist und auf dem Masse-Bezugspotential liegt. Wenn die Schottky-Diode SD gemäß den Fig. 1A bis Fig. 4A ausgeführt ist, kann die Leitbahnstruktur LB derart auf der Oberfläche des Halbleitersubstrats S angeordnet sein, dass sie den Bezugsanschluss B umgibt. Die Leitbahnstruktur LB verbessert die Güte der parasitären Diodenstrecken. Von den in den Gleichrichtern der Fig. 5A bis 8 verwendeten Schottky-Dioden können vorteilhaft selektiv eine oder mehrere mit einer solchen Leitbahnstruktur umgeben sein.

## Patentansprüche

1. Integrierter Schaltkreis (IC), insbesondere in CMOS-Technologie, mit
- einem passiven oder semipassiven, rückstreubasierten Transponder (TR) und
- einem Gleichrichter (GL1 bis GL6), der als Spannungsversorgung des Transponders und/oder als Detektorschaltung, insbesondere als RSSI-Schaltung, dient und Gleichrichterdioden (D1, D2), insbesondere Schottky-Dioden, umfasst,
**dadurch gekennzeichnet, dass**
- die Gleichrichterdioden (D1, D2) jeweils einen Bezugsanschluss (B1, B2) zum Anschluss an ein Bezugspotential, einen ersten Nutzanschluss (A1, A2, K1, K2) und einen zweiten Nutzanschluss (A1, A2, K1, K2) aufweisen, wobei die Diodenstrecke (D) zwischen dem ersten und dem zweiten Nutzanschluss (A1, A2, K1, K2) gebildet ist und zwischen dem Bezugsanschluss (B1, B2) und dem ersten Nutzanschluss (A1, A2, K1, K2) eine parasitäre Impedanz (RAB, CAB, RKB, CKB) besteht, und
- der erste Nutzanschluss (A1, A2, K1, K2) einer Gleichrichterdiode (D1, D2) und die Bezugsanschlüsse (B1,B2) der Gleichrichterdioden (D1,D2) auf dem Bezugspotential liegen.

2. Integrierter Schaltkreis nach Anspruch 1, **dadurch gekennzeichnet, dass** das Bezugspotential Massepotential ist.

3. Integrierter Schaltkreis nach Anspruch 1 oder 2, **dadurch gekennzeichnet, dass** zur Ausbildung der Gleichribhterdioden als Schottky-Dioden (D1, D2) jeweils ein dotierter Wannenbereich (W) in einem Halbleitersubstrat (S) vorgesehen ist und auf der Oberfläche des dotierten Wannenbereichs (W) der zweite Nutzanschluss (A1, A2, K1, K2) als Metall-Halbleiter-Übergang und der erste Nutzanschluss (A1, A2, K1, K2) mit Abstand zum zweiten Nutzanschluss (A1, A2, K1, K2) in einem Randbereich ausgebildet sind und der Bezugsanschluss (B1, B2) auf der Oberfläche des Halbleitersubstrats (S) benachbart zum dotierten Wannenbereich (W) ausgebildet ist.

4. Integrierter Schaltkreis nach einem der Ansprüche 1 bis 3, **dadurch gekennzeichnet, dass** der Gleichrichter (GL1 bis GL4) in Villardschaltung ausgeführt ist.

5. Integrierter Schaltkreis nach Anspruch 4, **dadurch gekennzeichnet, dass** diejenige Gleichrichterdiode (D1), die mit ihrem ersten, eine Anode (A1) bildenden Nutzanschluss mit dem Bezugspotential verbunden ist, als p-Schottky-Diode auf einem p-leitenden Halbleitersubstrat (S) ausgeführt ist.

6. Integrierter Schaltkreis nach Anspruch 4, **dadurch gekennzeichnet, dass** diejenige Gleichrichterdiode (D1), die mit ihrem ersten, eine Kathode (K1) bildenden Nutzanschluss mit dem Bezugspotential verbunden ist, als n-Schottky-Diode auf einem n-leitenden Halbleitersubstrat (S) ausgeführt ist.

7. Integrierter Schaltkreis nach einem der Ansprüche 1 bis 3, **dadurch gekennzeichnet, dass** der Gleichrichter (GL5, GL6) in Greinacherschaltung ausgeführt ist.

8. Integrierter Schaltkreis nach Anspruch 7, **dadurch gekennzeichnet, dass** diejenige Gleichrichterdiode (D1), die mit ihrem ersten, eine Anode (A1) bildenden Nutzanschluss mit dem Bezugspotential verbunden ist, als p-Schottky-Diode auf einem p-leitenden Halbleitersubstrat (S) ausgeführt ist und/oder diejenige Gleichrichterdiode (D2), die mit ihrem zweiten, eine Kathode (K2) bildenden Nutzanschluss mit einem Ausgangsanschluss (AA) des Gleichrichters verbunden ist, als n-Schottky-Diode auf einem p-leitenden Halbleitersubstrat (S) ausgeführt ist.

9. Integrierter Schaltkreis nach Anspruch 7, **dadurch gekennzeichnet, dass** diejenige Gleichrichterdiode (D1), die mit ihrem ersten, eine Anode (A1) bildenden Nutzanschluss mit dem Bezugspotential verbunden ist, als p-Schottky-Diode auf einem n-leitenden Halbleitersubstrat (S) ausgeführt ist und/oder diejenige Gleichrichterdiode (D2), die mit ihrem zweiten, eine Kathode (K2) bildenden Nutzanschluss mit einem Ausgangsanschluss (AA) des Gleichrichters verbunden ist, als p-Schottky-Diode auf einem n-leitenden Halbleitersubstrat (S) ausgeführt ist.

10. Integrierter Schaltkreis nach einem der vorhergehenden Ansprüche, **dadurch gekennzeichnet, dass** zur Verringerung der parasitären Eigenschaften der Gleichrichterdioden (D1, D2) Leitbahnstrukturen (LB) in geringem Abstand um diese angeordnet sind, die auf dem Bezugspotential liegen.

## Claims

1. Integrated circuit (IC), particularly in CMOS technology, comprising
- a passive or semi-passive backscatter-based transponder (TR) and
- a rectifier GL1 to GL6) which serves as voltage supply of the transponder and/or as a detector circuit, particularly as an RSSI circuit, and comprises rectifier diodes (D1, D2), particularly Schottky diodes,
**characterised in that**
- the rectifier diodes (D1, D2) each have a reference terminal for connection with a reference potential, a first work terminal (A1, A2, K1, K2) and a second work terminal (A1, A2, K1, K2), wherein the diode path (D) is formed between the first and the second work terminal (A1, A2, K1, K2) and a parasitic impedance (RAB, CAB, RKB, CKB) exists between the reference terminal (B1, B2) and the first work terminal (A1, A2, K1, K2) and
- the first work terminal (A1, A2, K1, K2) of one rectifier diode (D1, D2) and the reference terminals (B1, B2) of the rectifier diodes (D1, D2) lie at the reference potential.

2. Integrated circuit according to claim 1, **characterised in that** the reference potential is ground potential.

3. Integrated circuit according to claim 1 or 2, **characterised in that** for formation of the rectifier diodes as Schottky diodes (D1, D2) a respective doped trough region (W) is provided in a semiconductor substrate (S), and on the surface of the doped trough region (W) the second work terminal (A1, A2, K1, K2) is formed as a metal semiconductor transition and the first work terminal (A1, A2, K1, K2) is formed at a spacing from the second work terminal (A1, A2, K1, K2) in an edge region, and the reference terminal (B1, B2) is formed on the surface of the semiconductor substrate (S) adjacent to the doped trough region (W).

4. Integrated circuit according to any one of claims 1 to 3, **characterised in that** the rectifier (GL1 to GL4) is constructed in Villard connection.

5. Integrated circuit according to claim 4, **characterised in that that** rectifier diode (D1) which is connected with the reference potential by its first work terminal, which forms an anode (A1), is constructed as a p-Schottky diode on a p-conductive semiconductor substrate (S).

6. Integrated circuit according to claim 4, **characterised in that that** rectifier diode (D1) which is connected with the reference potential by its first work terminal, which forms a cathode (K1), is constructed as an n-Schottky diode on an n-conductive semiconductor substrate (S).

7. Integrated circuit according to any one of claims 1 to 3, **characterised in that** the rectifier (GL5, GL6) is constructed in Greinacher connection.

8. Integrated circuit according to claim 7, **characterised in that that** rectifier diode (D1) which is connected with the reference potential by its first work terminal, which forms an anode (A1), is constructed as a p-Schottky diode on a p-conductive semiconductor substrate (S) and/or that rectifier diode (D2) which is connected with an output terminal (AA) of the rectifier by its second work terminal, which forms a cathode (K2), is constructed as an n-Schottky diode on a p-conductive semiconductor substrate (S).

9. Integrated circuit according to claim 7, **characterised in that that** rectifier diode (D1) which is connected with the reference potential by its first work terminal, which forms an anode (A1), is constructed as a p-Schottky diode on an n-conductive semiconductor substrate (S) and/or that rectifier diode (D2) which is connected with an output terminal (AA) of the rectifier by its second work terminal, which forms a cathode (K2), is constructed as a p-Schottky diode on an n-conductive semiconductor substrate (S).

10. Integrated circuit according to any one of the preceding claims, **characterised in that** for reducing the parasitic characteristics of the rectifier diodes (D1, D2) conductor path structures (LB) lying at the reference potential are arranged at a small spacing around these.

## Revendications

1. Circuit intégré (IC), plus particulièrement CMOS, comprenant :
. un transpondeur (TR) passif ou semi-passif basé sur la rétrodiffusion, et
. un redresseur (GL1 à GL6), servant d'alimentation en tension au transpondeur et/ou de montage détecteur, plus particulièrement de circuit RSSI et comprenant des diodes à redresseur (D1, D2), plus particulièrement des diodes Schottky,
**caractérisé en ce que**
. les diodes à redresseur (D1, D2) présentent chacune une électrode de référence (B1, B2) pour la connexion à un potentiel de référence, une première électrode utile (A1, A2, K1, K2) et une deuxième électrode utile (A1, A2, K1, K2), la partie diode (D) étant formée entre la première et la deuxième électrode utile (A1, A2, K1, K2) et une impédance parasite (RAB, CAB, RKB, CKB) existant entre la première électrode de référence (B1, B2) et la première électrode utile (A1, A2, K1, K2), et
. **en ce que** la première électrode utile (A1, A2, K1, K2) d'une diode à redresseur (D1, D2) et les électrodes de référence (B1, B2) des diodes à redresseur (D1, D2) sont portées au potentiel de référence.

2. Circuit intégré selon la revendication 1, **caractérisé en ce que** le potentiel de référence est un potentiel de masse.

3. Circuit intégré selon la revendication 1 ou 2, **caractérisé en ce que** pour réaliser les diodes à redresseur sous la forme de diodes Schottky (D1 D2), on prévoit à chaque fois une zone en cuvette (W) dopée dans un substrat semi-conducteur (S), et qu'à la surface de la zone en cuvette (W) dopée, la deuxième électrode utile (A1, A2, K1, K2) est réalisé sous la forme d'une jonction métal-semi-conducteur et que la première électrode utile (A1, A2, K1, K2) est conformée à distance de la deuxième électrode utile (A1, A2, K1, K2) dans une zone périphérique, et **en ce que** l'électrode de référence (B1, B2) est conformée à la surface du substrat semi-conducteur (S) contiguë à la zone en cuvette (W) dopée.

4. Circuit intégré selon l'une quelconque des revendications 1 à 3, **caractérisé en ce que** le redresseur (GL1 à GL4) est conçu en montage Villard.

5. Circuit intégré selon la revendication 4, **caractérisé en ce que** la diode à redresseur (D1) qui est reliée au potentiel de référence par sa première électrode utile constituant une anode (A1), est réalisée sous la forme d'une diode Schottky positive sur un substrat semi-conducteur (S) à conduction par trous.

6. Circuit intégré selon la revendication 4, **caractérisé en ce que** la diode à redresseur (D1) qui est reliée au potentiel de référence par sa première électrode utile constituant une cathode (K1), est réalisée sous la forme d'une diode Schottky négative sur un substrat semi-conducteur (S) à conductibilité du type N.

7. Circuit intégré selon l'une quelconque des revendications 1 à 3, **caractérisé en ce que** le redresseur (GL5, GL6) est réalisé sous la forme d'un montage de Latour.

8. Circuit intégré selon la revendication 7, **caractérisé en ce que** la diode à redresseur (D1) qui est reliée au potentiel de référence par sa première électrode utile formant une anode (A1) est réalisée sous la forme d'une diode Schottky positive sur un substrat semi-conducteur (S) à conduction par trous, et/ou **en ce que** la diode à redresseur (D2) qui est reliée à une sortie (AA) du redresseur par sa deuxième électrode formant une cathode (K2) est réalisée sous la forme d'une diode Schottky négative sur un substrat semi-conducteur (S) à conduction par trous.

9. Circuit intégré selon la revendication 7, **caractérisé en ce que** la diode à redresseur (D1) qui est reliée au potentiel de référence par sa première électrode utile formant une anode (A1) est réalisée sous la forme d'une diode Schottky positive sur un substrat semi-conducteur (S) à conductibilité du type N, et/ou **en ce que** la diode à redresseur (D2) qui est reliée à la sortie (AA) du redresseur par sa deuxième électrode utile formant une cathode (K2) est réalisée sous la forme d'une diode Schottky positive sur un substrat semi-conducteur (S) à conductibilité du type N.

10. Circuit intégré selon l'une quelconque des revendications précédentes, **caractérisé en ce que** pour réduire les caractéristiques parasites des diodes à redresseur (D1, D2) des structures de circuit conducteur (LB) sont disposées à faible distance autour de celles-ci, qui sont portées au potentiel de référence.
